# EUROPEAN PATENT SPECIFICATION

(11) **EP 0 617 329 B1**
(45) Date of publication and mention of the grant of the patent: **31.10.2001**
(21) Application number: 94103534.7
(22) Date of filing: 08.03.1994
(51) Int. Cl.: G03F 7/00, G03F 1/14

(54) **Method of forming a micro structure and an X-ray mask**
Verfahren zur Herstellung einer Mikrostruktur und einer Röntgenstrahlmaske
Méthode pour fabriquer une microstructure et un masque pour rayons X

(30) Priority: 25.03.1993 JP 6667693
(43) Date of publication of application: 28.09.1994
(73) Proprietor: SUMITOMO ELECTRIC INDUSTRIES, LIMITED, Osaka 541 (JP)
(72) Inventor: Ogino, Seiji, c/o Osaka Works of, Konohana-ku, Osaka (JP); Numazawa, Toshiyuki, c/o Osaka Works of, Konohana-ku, Osaka (JP)
(74) Representative: Grosse, Wolfgang, Dipl.-Ing.

(56) References cited:
- EP-A- 0 141 335
- EP-A- 0 187 870
- DD-A- 277 773

## Description

### BACKGROUND OF THE INVENTION

### Field of the Invention

The present invention relates to a method of forming a micro structure and, more specifically, to an improvement in the method of forming micro structures such as LIGA method, improvement in the method of forming micro structures applying patterning technique of the semiconductor processing and the like, and to a method for forming an X-ray mask.

### Description of the Background Art

Recently, microprocessing technique for forming highly miniaturized structures by making use of technique for manufacturing semiconductor integrated circuit devices has been studied intensively. Especially the LIGA (Lithograph Galvanformung und Abformung) method for forming micro structures having high aspect ratio is attracting much attention (see Nikkei Mechanical 1990. November 26, pp. 72-79 and Kikai Sekkei Vol. 3, No. 6 (May, 1991), pp. 26-28). The LIGA method can be applied to manufacturing of micro machines, optical elements, sensors, actuators and the like, and the applicable field thereof is very wide.

In the conventional LIGA method, polymethylmethacrylate (PMMA) is mainly used as a resist in the step of forming a resist pattern by using X-ray lithography.

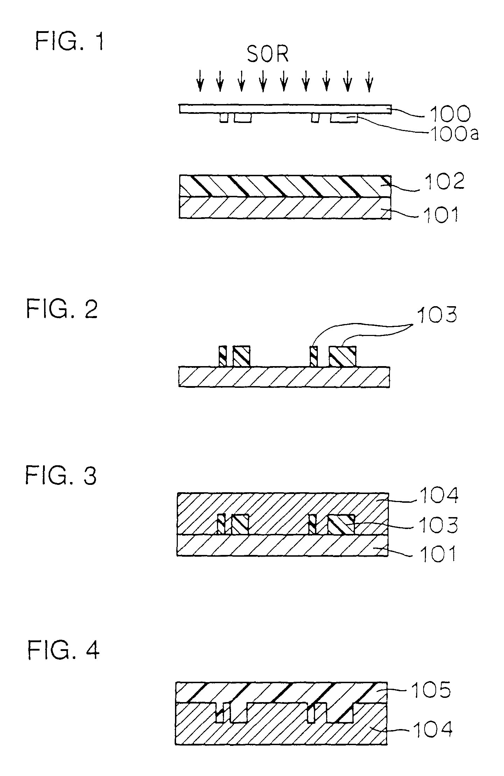

Figs. 1 to 8 are cross sections schematically showing basic steps of the conventional LIGA method.

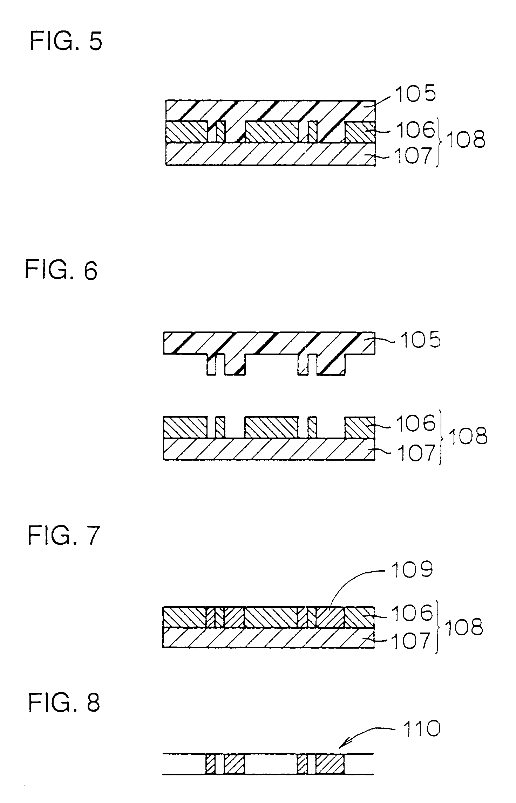

First, in the step shown in Fig. 1, typically, a resist layer 102 of polymethylmethacrylate (PMMA) is formed to a desired thickness (about several 10µm to several 100µm) on a substrate 101. Then, an X-ray mask 100 having a desired pattern is used to expose resist layer 102 with synchrotron orbital radiation (SOR). Then, in the step shown in Fig. 2, resist layer 102 which has been exposed in the step of Fig. 1 is developed to form a resist pattern 103. In the step shown in Fig. 3, substrate 101 having resist pattern 103 formed thereon is dipped in a plating liquid, and Ni, Cu, Au or the like is deposited on depressed portions of resist pattern 103 on substrate 101 by electroplating, thus forming a metal structure 104. In the step shown in Fig. 4, the substrate 101 and the resist are removed to obtain metal structure 104. Metal structure 104 is used as a mold, dielectric plastic is filled in metal structure 104 by injection molding, and thus a mold 105 of dielectric plastic is formed. Then, in the step shown in Fig. 5, in accordance with the mold 105 of dielectric plastic fabricated in the step of Fig. 4, a plastic mold 108 of dielectric plastic 106 and a conductive plastic sheet 107 is formed. Then, in the step shown in Fig. 6, mold 105 is separated to prepare a plastic mold 108. Then, in the step shown in Fig. 7, a metal 109 is deposited on the depressed portion of plastic mold 108 by electroforming. In the step shown in Fig. 8, plastic 108 is removed, and thus miniaturized metal structure 110 is obtained. The term "microstructure" used in this specification includes, but is not limited to, metal structure 104 formed in the step of Fig. 3, mold 105 formed in the step of Fig. 4, plastic mold 108 formed in the step of Fig. 5 and metal structure 110 formed in the step of Fig. 8.

Degree of integration of semiconductor integrated circuit has been much increased these days, and as the degree becomes higher in VLSIs (Very Large Scale Integrated Circuits), it becomes necessary in the field of manufacturing semiconductor integrated circuits and the like to miniaturize element structures of the semiconductor devices. To meet this demand, X-ray (having the wavelength of about 10Å) lithography method using light having shorter wavelength than the conventional photolithography employing ultraviolet rays (having the wavelength in the range of about 3000Å to about 5000Å) has come to attract attention.

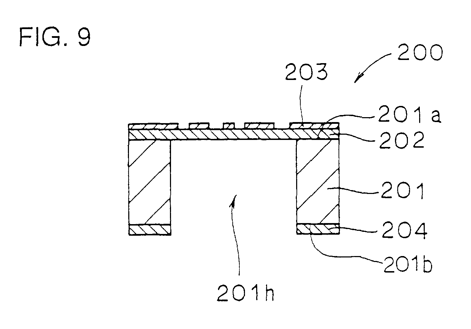

Fig. 9 is a cross section schematically showing an X-ray mask used in the X-ray lithography in patterning such a conventional semiconductor integrated circuit. Referring to Fig. 9, the X-ray mask 200 includes a silicon substrate 201 having an opening 201h at the central portion, an X-ray transmitting membrane 202 provided to cover one surface 201a of silicon substrate 201, and an X-ray absorber film 203 having a desired pattern formed on the surface of X-ray transmitting membrane 202. X-ray transmitting membrane 202 is formed of a material which transmits X-ray, that is, having high transmittance of X-ray, such as silicon nitride (SiN) or silicon carbide (SiC).

Meanwhile, X-ray absorber film 203 is formed of a material which absorbs much X-ray, that is, a material having low X-ray transmittance such as tungsten (W) or tantalum (Ta). X-ray absorber film 203 is supported by X-ray transmitting membrane 202. On the other surface 201b of silicon substrate 201, a film 204 of silicon nitride (SiN), silicon carbide (SiC) or the like is formed. Average thickness of X-ray absorber film 203 in the conventional X-ray mask is about 0.7µm.

The method of manufacturing a conventional photomask will be described in the following.

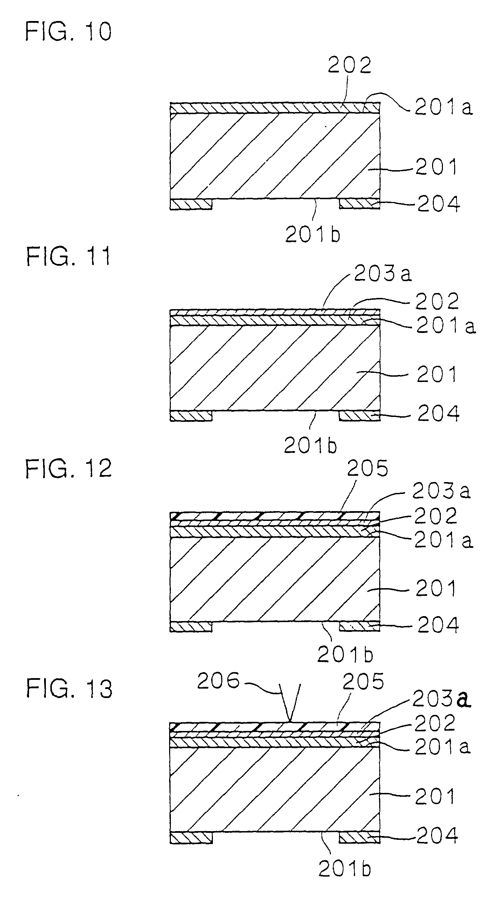

Figs. 10 to 17 are cross sections schematically showing the steps of manufacturing a conventional X-ray mask. First, in the step shown in Fig. 10, X-ray transmitting membrane 202 of silicon nitride (SiN), silicon carbide (SiC) or the like having the thickness of about 2µm is formed on one surface 201a of silicon substrate 201 by chemical vapor deposition (CVD) or physical vapor deposition (PVD). In this step, film 204 of silicon nitride (SiN), silicon carbide (SiC) or the like serving as an etching mask for etching back silicon substrate 201 in the subsequent step, which will be described later, is formed on a prescribed region on the other surface 201b of silicon substrate 201 by chemical vapor deposition or physical vapor deposition. In the step shown in Fig. 11, X-ray absorber film 203a of tungsten (W), tantalum (Ta) or the like is formed by chemical vapor deposition or physical vapor deposition on the surface of X-ray transmitting membrane 202. The thickness of X-ray absorber film 203a is about 0.7µm. In the step shown in Fig. 12, a resist layer 205 is formed by spin coating by using a resist on the surface of X-ray absorber film 203a.

A method of applying a resist on the surface of X-ray absorber film 203a by spin coating will be described by way of example. First, a prescribed amount of the resist is dropped from a nozzle on the surface of X-ray absorber film 203a and left as it is for a while, so that the resist spreads on the surface of X-ray absorber film 203a. Then, by rotating silicon substrate 201 at high speed by using a spinner or the like, excessive resist is scattered/spread, thereby forming a resist layer 205 having uniform thickness. The thickness of resist layer 205 formed on the surface of X-ray absorber film 203a is normally 3µm or less, though it depends on the viscosity of resist applied, the number of rotation of the spinner, and the speed of gasification/gasifier of the solvent.

Then, in the step shown in Fig. 13, a pattern is drawn on resist layer 205 (i.e., the resist layer is exposed) to provide a desired mask absorber by using electron beam 206 emitted from an electric gun (an electron beam emitting apparatus, which is not shown). In the step of Fig. 13, when a resist for photolithography is used, resist layer 205 may be exposed with ultra violet ray (having the wavelength in the range of about 3000Å to about 5000Å) to provide a desired mask absorber.

In the step shown in Fig. 14, by developing the exposed resist layer 205, a desired resist pattern 205a is formed. In the step shown in Fig. 15, using resist pattern 205a as a mask, X-ray absorber film 203a exposed through opening portions 205b is etched so that X-ray absorber film 203a is penetrated, by dry etching such as reactive ion etching (RIE). Then in the step shown in Fig. 16, the resist layer is removed, the film 204 is used as an etching mask, and silicon substrate 201 is removed by etching (back etching) from the other surface 201b of the substrate 201 to X-ray transmitting membrane 202 by dry etching such as reactive ion etching, wet etching or the like, and thus an X-ray mask 200 is formed (see Fig. 17).

Again referring to Fig. 13, by using electron beam 206 or ultraviolet ray (having the wavelength in the range of 3000Å to 5000Å) resist layer 205 can be exposed with sufficiently high precision in a desired shape to the depth of at most 2µm in the thickness direction (depth direction) of resist layer 205. The reasons for this are that the electron beam or the ultraviolet ray (having the wavelength of 3000Å to 5000Å) is absorbed by the resist, and that precision of the resist pattern is decreased by diffraction of light, and so on.

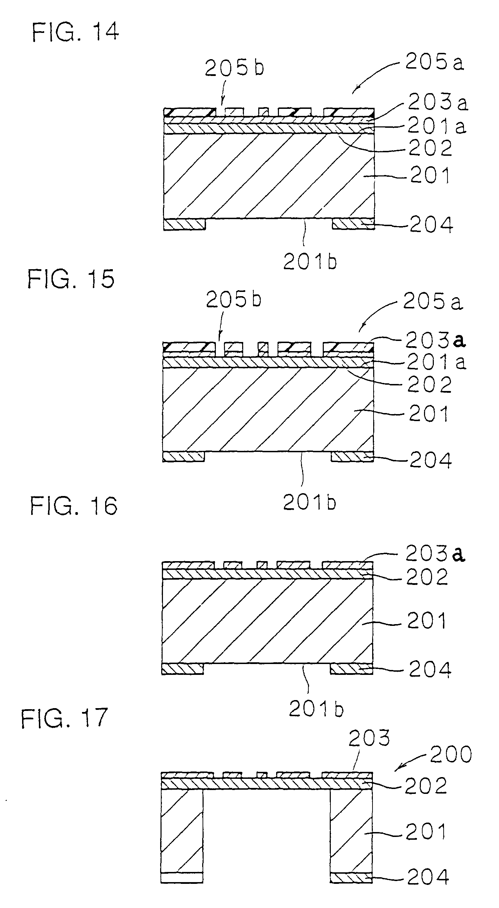

Referring again to Fig. 15, in the step of etching X-ray absorber film 203a by using resist pattern 205a as a mask, in order to etch X-ray absorber film 203a deep in the thickness direction (depth direction) of the membrane 203a, it is necessary to increase the selection ratio represented by the following equation (1):$\text{selection ratio} \text{=} \frac{\text{etch rate of X-ray absorbing membrane}}{\text{etch rate of resist}}$

However, though various etching gases (reaction gases) are used, there is a limit in increasing the selection ratio.

As mentioned above, the thickness of the X-ray absorber film of the conventional X-ray mask is about 0.7µm.

The reason why the thickness of the X-ray absorber film of the conventional X-ray mask is about 0.7µm will be described.

First, in the conventional method of manufacturing an X-ray mask shown in Figs. 10 to 17, it was difficult to make the X-ray absorber film thicker than 0.7µm. More specifically, in the conventional method of manufacturing the X-ray mask, the resist layer is formed by spin coating, and therefore it is difficult to make thick the resist layer. In addition, it was difficult to form deep resist pattern with high precision in the depth direction of the resist layer due to diffraction of light, intensity of exposure light source which is not sufficiently strong and so on, as the resist layer is exposed by electron beam or ultra violet ray (which has the wavelength of about 3000Å to about 5000Å). In addition, there is a limit in increasing the selection ratio of the etch rate of the resist layer and the etch rate of the X-ray absorber film, as described above.

As a second reason, in the field of manufacturing semiconductor devices, light having the wavelength in the range of about 10Å to about 4000Å is generally used in the step of exposure during lithography. Therefore, when the X-ray absorber film is made thick, resolution of patterns to be transferred onto the resist layer is decreased by the diffraction effect of light.

In accordance with the conventional method of manufacturing the X-ray mask shown in Figs. 10 to 17, even if the selection ratio of the equation (1) is increased, the thickness of the X-ray absorber film which can be patterned is at most 3µm.

In lithography used in the process of manufacturing semiconductors, a copolymer resist including methylmethacrylate (MMA) and methacrylic acid (MAA) has been known (see J. Electrochem., Soc., Vol. 1126, No. 1 (1979), pp. 154∼161).

In the step of forming a resist layer on the semiconductor substrate during lithography used in the process of manufacturing semiconductors, normally spin coating is employed.

A method of applying a copolymer resist including methylmethacrylate and methacrylic acid units on a semiconductor substrate will be described by way of example.

In lithography employed in the process of manufacturing semiconductors, the copolymer resist including methylmethacrylate and methacrylic acid units is produced by polymerizing methylmethacrylate monomer and methacrylic acid monomer in a solvent such as toluene. The copolymer including methylmethacrylate and methacrylic acid units produced in the solvent such as toluene is precipitated by methanol or the like. The copolymer including methylmethacrylate and methacrylic acid units is purified, and then dissolved in a solvent such as ethyl cellosolve acetate (ECA). The solution including the copolymer including methylmethacrylate and methacrylic acid units is dropped on a semiconductor substrate and applied to have a prescribed uniform thickness on the semiconductor substrate by spin coating. Then, the semiconductor substrate on which the solution has been applied is subjected to thermal processing to remove the solvent, and thus a copolymer resist layer including methylmethacrylate and methacrylic acid units is formed on the semiconductor substrate. The thickness of the resist layer formed in this manner on the semiconductor substrate is 3µm or less.

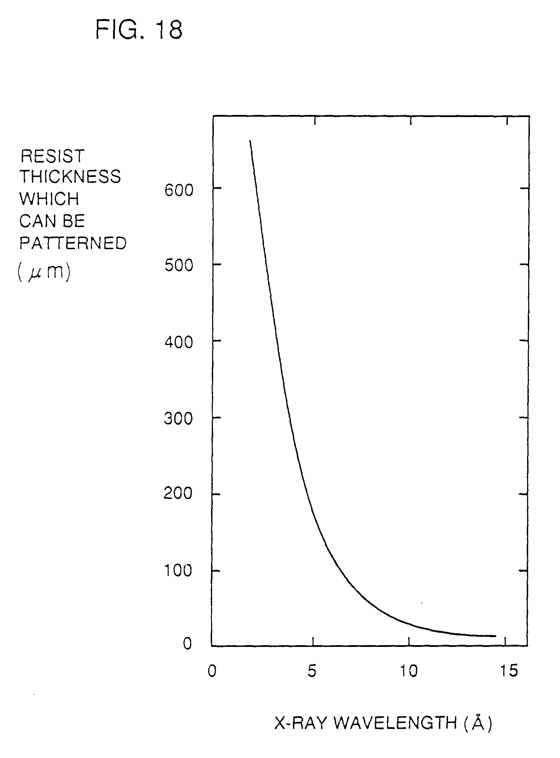

Now, in the field of forming micro structures using LIGA method and the like described above, since the resist formed of PMMA does not much absorb X-ray, long period of exposure by using a large scale·high performance synchrotron orbital radiation apparatus having high light intensity has been inevitable. In order to obtain a resist pattern having high resolution, the diffraction effect of light must be decreased, and in order to realize deeper exposure in the vertical direction (about several 10µm or more), synchrotron orbital radiation of short wavelength (of about 2Å to about 5Å) is necessary. Fig. 18 is a graph showing relation between the thickness (depth) of the resist which can be patterned in the thickness direction (depth direction) of the resist layer including generally employed polymethylmethacrylate (PMMA) and the wavelength of the X-ray. Referring to Fig. 18, theoretically, it is possible to pattern deeply with high precision in the thickness direction (depth direction) of the resist layer by forming thick the resist layer, using light of short wavelength and by reducing diffraction effect of light.

Therefore, especially in the field of LIGA method, in order to form micro structures having high aspect ratio, a synchrotron orbital radiation apparatus which can emit synchrotron orbital radiation of short wavelength (of about 2Å to about 5Å) with high light source intensity for a long period of time has been desired.

However, use of such synchrotron orbital radiation apparatus is generally difficult.

Micro structures such as micro machines, optical elements, sensors, actuators and the like must have sufficient mechanical strength, and for this reason, it is necessary to form structures having portions finely processed in the order of µm and having high aspect ratio. Such micro structures have various thicknesses dependent on the applications and purposes of such structures, and normally the thickness varies in the range of about 1µm to 1mm. When a micro structure such as a micro machine is to be formed by LIGA method, it is necessary to make the resist layer 102 thick (several 10µm to several 1,000µm) to form deep resist patterns in the thickness direction (depth direction) of the resist layer, as compared with the manufacturing of the semiconductor integrated circuits, as can be seen from Fig. 1. Therefore, when micro structures are to be formed by LIGA method or the like, it is necessary to carry out exposure for a long period of time by the synchrotron orbital radiation having the short wavelength (of about 2Å to 15Å) by using the X-ray mask 100, to reduce diffraction effect of light and to expose the resist layer deep in the thickness direction (depth direction).

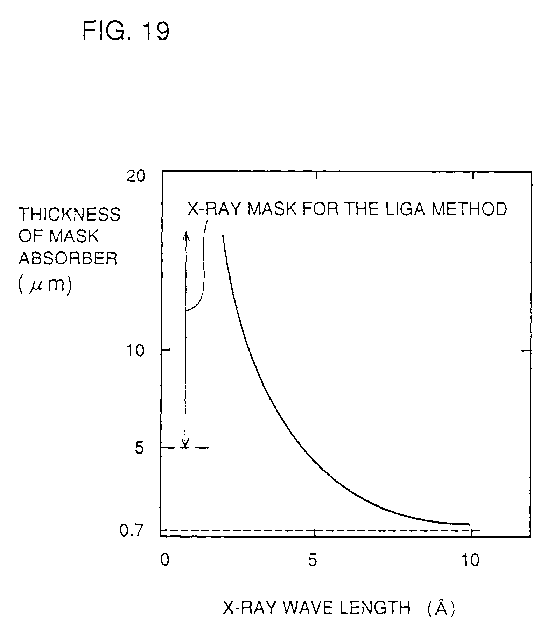

Fig. 19 is a graph showing relation between the film thickness of a necessary X-ray absorber as the X-ray mask used in manufacturing micro machines and the like by LIGA method and the wavelength of the X-ray. Referring to Fig. 19, when micro machines and the like are to be manufactured by LIGA method, average thickness of the X-ray absorber of the X-ray mask must be at least 5µm. More specifically, the conventional X-ray mask used in manufacturing semiconductor integrated circuits has the X-ray absorber with average thickness of about 0.7µm so that when the resist layer 102 is irradiated with synchrotron orbital radiation for a long period of time using the X-ray mask 100, the synchrotron orbital radiation passes through the X-ray absorber film 100a, causing exposure of portions not requiring exposure of the resist layer 102, and therefore desired resist pattern cannot be obtained.

For manufacturing micro machines and the like by LIGA method, an X-ray mask having an X-ray absorption membrane which can sufficiently intercept the synchrotron orbital radiation even when it is long exposed to the synchrotron orbital radiation, that is, an X-ray mask having the X-ray absorber film with average film thickness of at least 5µm has been long in demand. Meanwhile, the average film thickness of the X-ray absorber film formed by the conventional method of manufacturing the X-ray mask is about 0.7 µm and it is difficult to manufacture a X-ray mask having the thickness of 3 µm or thicker as the average thickness of the X-ray absorber film by the conventional method of manufacturing the X-ray mask.

Document EP 187 870 A1 discloses a method for forming microstructures in a resist on a substrate by use of X-rays wherein copolymers including methylmethacrylate and methacrylic acid units are used as resist layers.

Document EP 141 335 A1 discloses a method for forming an X-ray mask wherein a resist pattern of PMMA is formed by X-ray lithography.

### SUMMARY OF THE INVENTION

An object of the present invention is to provide a method of forming highly precise micro structures having high aspect ratio.

Another object of the present invention is to provide a method of forming micro structures employing the above described LIGA method by which highly precise micro structures having high aspect ratio can be formed by selecting an appropriate resist.

A still another object of the present invention is to provide a method of forming micro structures including, at the time of effecting lithography, the step of selecting an appropriate resist and a novel step of forming the resist thick on the substrate, whereby highly precise micro structures having high aspect ratio can be formed.

A still further object of the present invention is to provide a method for forming an X-ray mask appropriately used in the step of lithography in a method of forming micro structures.

The resist used in the step of lithography for forming micro structures is required to have the following characteristics:
· highly sensitive;
· having high resolution;
· the resist layer can be formed thick in the vertical direction with respect to the susbtrate; and
· when the resist layer is formed thick, vertically deep exposure in the depth direction of the resist is possible, enabling formation of a resist pattern having high aspect ratio.

The inventors have intensively studied the method of forming micro structures having high aspect ratio and found that copolymer resist including methylmethacrylate and methacrylic acid units used in lithography in the process of manufacturing semiconductors has higher sensitivity than PMMA, and that the copolymer including methylmethacrylate and methacrylic acid units is suitable as a resist used in the step of lithography for forming micro structures, which findings lead to the completion of the present invention.

The method of forming a micro structure in accordance with the present invention includes the steps of forming a resist layer on a substrate, and patterning the resist layer, wherein the step of forming the resist layer on the substrate includes the steps of pre-polymerizing a monomer generally represented as 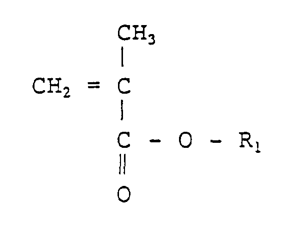 [In the formula R₁, represents an alkyl group having one to four carbon atom(s) (the hydrogen atom of the alkyl group may be substituted for by a halogen atom)] and a monomer generally represented as 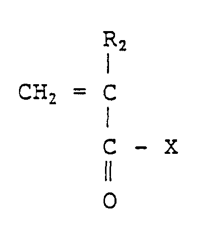 [In the formula X represents a halogen atom or hydroxyl group and R₂ represents a hydrogen atom or a methyl group] for preparing a copolymer syrup, applying the copolymer syrup on the substrate, and fully polymerizing the copolymer syrup layer formed on said substrate by the step of application, on the susbtrate.

Preferably, in the method of forming a micro structure in accordance with the present invention, the step of patterning includes the step of forming a resist pattern by lithography on the resist layer by synchrotron orbital radiation.

Preferably, the method of forming a micro structure in accordance with the present invention includes the steps of forming a resist layer on a substrate surface, forming a resist pattern having an opening by lithography on the resist layer by synchrotron orbital radiation, and removing the portion of the substrate which is exposed through said opening by using said resist pattern as a mask, wherein
said step of forming the resist layer on the substrate surface includes the step of pre-polymerizing a monomer generally represented as 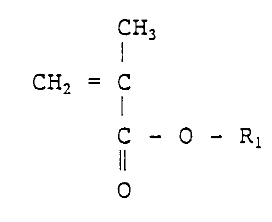 [In the formula, R₁ represents an alkyl group having one to four carbon atom(s) (the hydrogen atom of the alkyl roup may be substituted for by a halogen atom)] and a monomer generally represented as 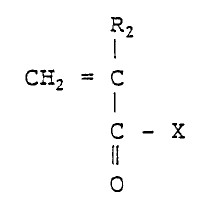 [In the formula, X represents a halogen atom or a hydroxyl group and R₂ represents a hydrogen atom or methyl group] for preparing a copolymer syrup, the step of applying the copolymer syrup on the surface of the substrate, and fully polymerizing the copolymer syrup formed by the step of application on the surface of the substrate.

The X-ray mask formed by a method in accordance with the present invention includes an X-ray transmitting membrane formed of a material which transmits X-ray, and an X-ray absorber film formed on the surface of the X-ray transmitting membrane, and the average film thickness of the X-ray absorber film is at least 5µm.

The copolymer resist used in the present invention can be represented by way of example by the following formula: 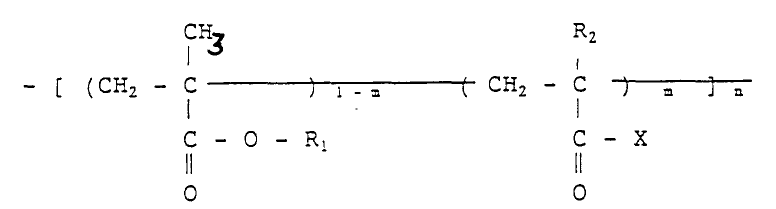 [In the formula, R₁ represents an alkyl group having one to four carbon atom(s) (the hydrogen atom of the alkyl group may be substituted for by a halogen atom), X represents a halogen atom or a hydroxyl group, and R₂ represents a hydrogen atom or a methyl group].

Various resist material monomers used in lithography in the process of manufacturing semiconductors may be used as the methacrylic acid ester (monomer) used in the present invention. The methacrylic acid ester (monomer) used in the present invention can be generally represented as: 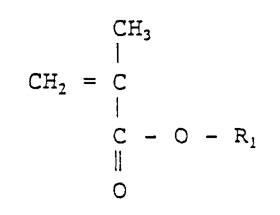 [In the formula, R₁ represents an alkyl group having one to four carbon atom(s) (the hydrogen atom of the alkyl group may be replaced by a halogen atom)].

In the formula, R₁ includes n-alkyl group, a primary alkyl group, a secondary alkyl group and a tertiary alkyl group.

Specific examples of the methacrylic acid ester used in the present invention includes, for example, methylmethacrylate, 2-fluoro ethyl methacrylate, 2,2,2-trifluoro ethyl methacrylate, tetra fluoroisopropyl methacrylate, hexafluorobutyl methacrylate, 2-chloroethyl methacrylate and 2-bromoethyl methacrylate (see Solid State Technology/Japanese version/February 1990, pp.28-35).

Various monomers represented by the following formula may be used as the monomer for copolymerization with the above mentioned methacrylic acid ester of the copolymer resist used in the present invention: 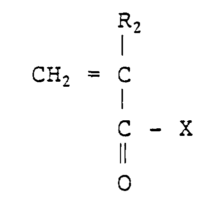 [In the formula, X represents a halogen atom or a hydroxyl group, and R₂ represents a hydrogen atom or a methyl group].

Specific examples of such monomers include, for example, methacrylic acid, methacryloyl halogenoid, acryl acid, acryloyl halogenoid and so on.

The term "pre-polymerizing" means mixing monomers and polymerizing the mixed monomers to a prescribed amount, so that part of the mixed monomers and produced copolymer exist together.

The term "copolymer syrup" used in the specification means a syrup in which part of the mixed monomers and the produced copolymer exist together.

At a portion irradiated by synchrotron orbital radiation (expose portion), the primary chain of the copolymer resist of the present invention is disconnected and the copolymer resist turns to a water soluble substance having a carboxyl group at its end. Thus its solubility in an alkalic developer which the development of chemical amplification resist used and in a developer such as ethyl cellosolve acetate (ECA), methyl cellosolve acetate, cyclopentane and methylisobutylketone is increased, so that it becomes soluble in a developer. In the step of forming a resist pattern by lithography on the resist by synchrotron orbital radiation, exposure time (T) necessary for lithography is determined by the intensity (I) of the exposure light source and sensitivity (S) of the resist, as represented by the equation (2).$\text{T = S/I}$

The copolymer resist mentioned above in accordance with the present invention has high responsiveness, and therefore the value of sensitivity (S) in the above equation (2) can be made small. Since the value of sensitivity (S) in the equation (2) is decreased, the exposure time can be shortened without increasing the intensity of the exposure light source.

When the copolymer resist mentioned above is used, deeper exposure in the vertical direction is enabled even when intensity of the exposure light source is weak, for example, even if synchrotron orbital radiation having long wavelength is used, as the sensitivity of the resist is high.

Resolution of the resist can be improved by reducing diffraction effect of light, that is, by employing light having short wavelength. By using the copolymer resist mentioned above in accordance with the present invention, the resolution can be also improved by chemical reaction mechanism and development mechanism of the resist.

As described above, by the copolymer resist mentioned above in accordance with the present invention, a resist pattern having high aspect ratio can be formed with smaller amount of irradiation. Therefore, a micro structure having high aspect ratio can be obtained by carrying out normal electroplating, electroforming and the like in accordance with the obtained resist pattern. By etching a substrate portion which is exposed through an opening of the resist pattern, using the resist pattern as a mask, a micro structure having high aspect ratio and having a recess in the depth direction of the substrate can be obtained.

When the resist is formed on the surface of the substrate through the steps of pre-polymerizing a monomer generally represented as 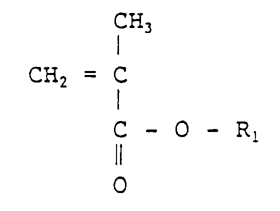 [In the formula, R₁ represents an alkyl group including one to four carbon atom(s) (the hydrogen atom of the alkyl group may be replaced by a halogen atom)], and a monomer generally represented as 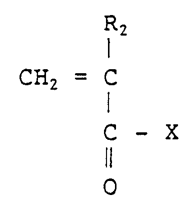 [In the formula, X represents a halogen atom or a hydroxyl group and R₂ represents a hydrogen atom or a methyl group] to prepare a copolymer syrup including these, applying the copolymer syrup on the surface of the substrate and fully polymerizing the copolymer syrup formed on the surface of the substrate by the step of application on the surface of the substrate, the resulting resist can be made thicker than the resist formed by the conventional spin coating method.

In accordance with the present invention, a resist is formed thick on a surface of a substrate, a resist pattern having an opening is formed, the substrate portion exposed through the opening is etched away using the resist pattern as a mask, whereby the substrate can be etched deeper in the depth direction as compared with the conventional example in which the resist is formed by spin coating on the surface of the substrate, without increasing the selection ratio indicated by the equation (1), as the resist film can be formed thicker.

Further, the X-ray mask formed by a method in accordance with the present invention includes an X-ray absorber film the average thickness of which is at least 5µm. Therefore, when a resist pattern is formed by lithography on the resist formed on the substrate with synchrotron orbital radiation using the X-ray mask in accordance with the present invention, the X-ray absorber film can sufficiently intercept the synchrotron orbital radiation even if the resist is exposed to the synchrotron orbital radiation of a prescribed intensity for long period of time through the X-ray mask of the present invention. Accordingly, a resist pattern having high aspect ratio can be formed with high precision. By using the X-ray mask formed by a method in accordance with the present invention, a resist pattern having higher aspect ratio can be formed as compared with the lithography using the conventional X-ray mask which is generally used in manufacturing semiconductor integrated circuits, and therefore by carrying out normal electroplating, electroforming and the like in accordance with the obtained resist pattern, a microstructure having higher aspect ratio can be obtained.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1 to 8 are cross sections schematically showing first to eighth basic steps of the conventional LIGA method.

Fig. 9 is a cross section schematically showing an X-ray mask used in the conventional X-ray lithography.

Figs. 10 to 17 are cross sections schematically showing the first to eighth steps of forming the X-ray mask used in the conventional X-ray lithography.

Fig. 18 is a graph showing relation between the thickness of the resist which can be patterned in the thickness direction of the resist formed of polymethylmethacrylate (PMMA) and the wavelength of the X-ray.

Fig. 19 is a graph showing relation between the necessary thickness of X-ray absorber as the X-ray mask used in manufacturing micro machines and the like by the LIGA method, and the wavelength of X-ray.

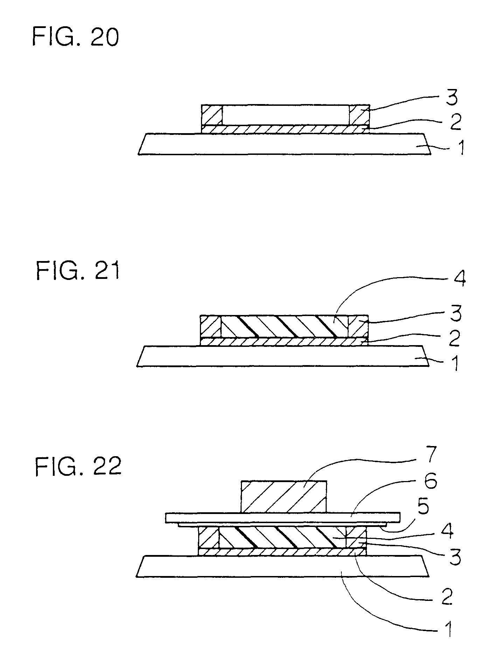

Figs. 20 to 22 are cross sections schematically showing the first to third steps for forming a copolymer resist including methylmethacrylate and methacrylic acid units on a substrate.

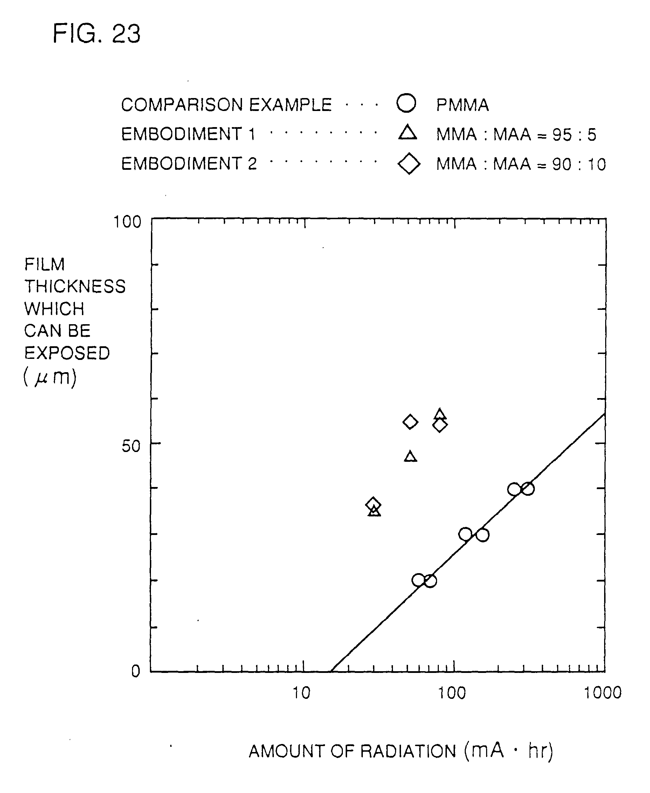

Fig. 23 is a graph showing thickness (µm) which can be exposed with respect to the amount of radiation (mA·hour) of the synchrotron orbital radiation of polymethylmethacrylate (PMMA) and resists formed in accordance with the present invention.

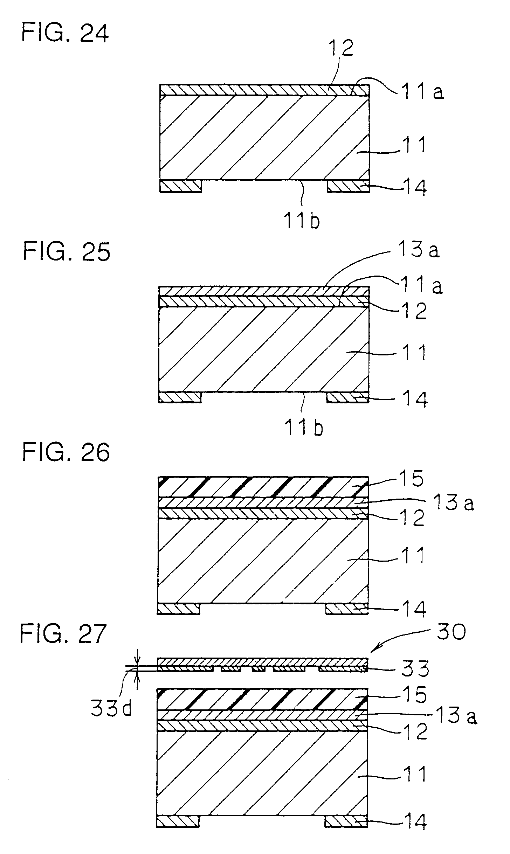

Figs. 24 to 31 are cross sections schematically showing the first to eighth steps of manufacturing the X-ray mask in accordance with the present invention.

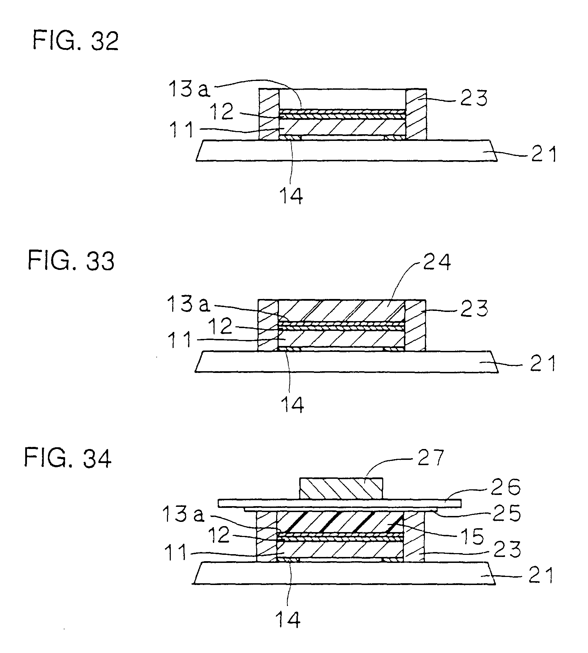

Figs. 32 to 34 are cross section schematically showing the first to third steps of forming a copolymer resist including methylmethacrylate and methacrylic acid units on a susbtrate in accordance with the present invention, which show details of the step shown in Fig. 26.

### DESCRIPTION OF THE PREFERRED EMBODIMENTS

### Embodiment 1

### (1) Preparation of copolymer syrup

### Example 1

In a mixture of 95g (0.95 mole) of methylmethacrylate monomer (molecular weight 100) and 5g (0.051 mole) of methacrylic acid (molecular weight 86), 0.2g (about 0.2wt% with respect to the mixed monomer) of 2,2'-azobis (isobutyronitrile) (AlBN) was added as polymerization initiator, pre-polymerization was effected for 50 minutes at 60°C in N₂ gas atmosphere by bulk polymerization, and a copolymer syrup of methylmethacrylate and methacrylic acid units was produced. The weight average molecular weight of this copolymer syrup including methylmethacrylate and methacrylic acid units was 400,000.

### Example 2

In a mixture of 90g (0.90 mole) of methyl.methacrylate monomer (molecular weight 100) and 10g (0.116 mole) of methacrylic acid (molecular weight 86), 0.2g (about 0.2 wt. % with respect to the mixture of monomers) of 2, 2'-azobis(isobutyronitrile)(AlBN) was added as polymerization initiator, pre-polymerization was effected for 50 minutes at 60°C in N₂ gas atmosphere by bulk polymerization, and a copolymer syrup including methylmethacrylate and methacrylic acid units was produced. The weight average molecular weight of this copolymer syrup including methylmethacrylate and methacrylic acid units was 500,000.

### (2) Formation of the Resist

Figs. 20 to 22 are cross sections schematically showing the steps of forming a copolymer resist including methylmethacrylate and methacrylic acid units on a substrate in accordance with one embodiment of the present invention.

In the step shown in Fig. 20, a silicon substrate 2 is placed on a hot plate 1, and a spacer 3, such as made of stainless steel for instance, is placed on the silicon susbtrate 2. In the step shown in Fig. 21, the copolymer syrup 4 including methylmethacrylate and methacrylic acid units produced in the manner as described above is dropped to fill spacer 3. In the step shown in Fig. 22, "Kapton sheet" (mold releasing sheet made of polyimide) 5 is placed on spacer 3, a metal plate 6 is placed on Kapton sheet 5, and a weight 7 is placed on metal plate 6, and then it is kept at 70°C by the hot plate 1 for one hour, so that copolymer syrup 4 including methylmethacrylate and methacrylic acid units is fully polymerized on silicon substrate 2. "Kapton" is a registered trademark of Du Pont.

By the above described steps, a copolymer resist including methylmethacrylate and methacrylic acid units could be formed to the thickness in the range of 50µm to 350µm on silicon susbtrate 2. Resist layer having various thicknesses (several 10µm to 1mm) can be formed by changing the thickness (height) of spacer 3.

Then, silicon substrate 2 having the resist formed thereon is prebaked by heating the same from room temperature to 200°C in one hour, keeping the same at 200°C for three hours and cooling the same from 200°C to the room temperature in three hours.

The prebaking is carried out to remove internal stress in the resist formed on silicon susbtrate 2 and to improve adhesiveness of the resist and silicon substrate 2. The temperature is not limited to 200°C, provided that it is not lower than glass transition point (about 160°C) of the copolymer including methylmethacrylate and methacrylic acid units. The time required for increasing temperature, the time for keeping constant temperature and the time required for lowering the temperature are not limited. However, the substrate must be kept sufficiently long at a high temperature in order to improve adhesiveness of the silicon substrate 2 and the copolymer resist including methylmethacrylate and methacrylic acid units.

In order to reduce cracks, it is preferable to make longer the time for cooling than the time for increasing the temperature. In this manner, generation of cracks can be prevented by lowering stress generated in the copolymer resist due to the difference in thermal expansion coefficients of the silicon substrate 2 and the copolymer including methylmethacrylate and methacrylic acid units.

### (3) Evaluation of the resist and the resist pattern

Then, synchrotron orbital radiation of the 0th order having the peak wavelength of about 10µm is directed through a Be window using a mask with openings of a desired pattern, by a synchrotron orbital radiation apparatus (TERAS of Electrotechnical Laboratory Agency of Industrial Science and Technology).

The amount of irradiation was 30mA·hour to 90mA·hour in terms of the accumulated beam current.

Then, silicon substrate 2 having the resist exposed in the above manner is dipped for about 2 minutes in methylisobutylketone (MIBK) non-diluted liquid at room temperature, with the silicon substrate 2 kept still.

Fig. 23 shows relation between the thickness (µm) which can be exposed and the amount of radiation (mA•hour) of synchrotron orbital radiation, of the conventional resist (polymethylmethacrylate (PMMA)) and the resist formed of copolymer including methylmethacrylate and methacrylic acid units formed in accordance with the present invention.

As is apparent from Fig. 23, each of the resist provided by fully polymerizing the copolymer of the Examples 1 and 2 described above on the substrate 2 can be exposed deeper with smaller amount of radiation as compared with the conventional resist of PMMA. More specifically, the resist of the copolymer including methylmethacrylate and methacrylic acid units formed in accordance with the present invention is highly sensitive as compared with the conventional PMMA, and when the resist of copolymer including methylmethacrylate and methacrylic acid units is formed thick on the substrate in accordance with the present invention, deep exposure is possible. Accordingly, the resist pattern formed by development has a resist pattern deep in the vertical direction with less die wear, with high resolution.

The sensitivity of the resists provided by fully polymerizing the copolymer syrups including Examples 1 and 2 were approximately the same. The amount of synchrotron orbital radiation and vertical depth of the resist pattern of PMMA and the resist of copolymers including methylmetacrylate and methacrylic acid units formed in accordance with the present invention were compared. The results of comparison were as shown in Table 1 below.

**Table 1**

| Resist | Amount of Radiation (mA•hr) | Depth (µm) |
|---|---|---|
| Example 1 | 30 | 35 |
| Example 2 | 30 | 35 |
| Example for Comparison | 200 | 35 |

As is apparent from Table 1, when the synchrotron orbital radiation of the same amount of accumulated current (mA•hour) is used, the time of exposure necessary to obtain the same depth can be reduced to about 1/7 in accordance with the present invention. In other words, if the resist of the present invention is used, a resist pattern deep in the vertical direction can be fabricated efficiently in a short period of time.

As compared with the method of applying copolymer resist including methylmethacrylate and methacrylic acid units by spin coating in the process of semiconductors, the copolymer resist includig methylmethacrylate and methacrylic acid units can be formed thick on the substrate by the present embodiment.

Though the copolymer resist including methylmethacrylate and methacrylic acid units is formed thick in the present embodiment, the copolymer resist can be exposed deep without generating positive/negative inversion by one exposure and a resist pattern deep in the vertical direction could be formed. More specifically, at the exposed portion of the positive resist, the principal chain of the polymer is disconnected and polymerization is caused by the generated radicals. Accordingly, in the positive resist, the amount of generated radical increases because of the aforementioned disconnection reaction, and when the disconnection reaction and polymerization reaches an equilibrium or when the polymerization proceeds further than decomposition reaction, the resist comes to be insoluble in the developer even if it is further exposed. However, such positive/negative inversion is suppressed in the present embodiment, which enables deep exposure at one time.

The copolymer resist including methylmethacrylate and methacrylic acid units formed in accordance with the present invention has higher transmittance of X-ray than PMMA, which is considered to be a contribution to deeper exposure.

In this embodiment, a resist pattern having the depth in the range from about 10µm to about 1mm can be formed with high sensitivity, high resolution and high aspect ratio in the present embodiment, micro structures of various materials requiring the thickness in the range from about 10µm to about 100µm can be formed with high aspect ratio, with precision in a short period of time, for example, by depositing metal in accordance with the resist pattern.

In this embodiment, the copolymer resist including methylmethacrylate and methacrylic acid units is formed by bulk polymerization. Therefore, in the present invention, different from the conventional method in which the resist is formed by spin coating, the step of removing solvent is not necessary.

In the present embodiment, the copolymer resist including methylmethacrylate and methacrylic acid units formed on the substrate in accordance with the present embodiment does not include any solvent in the resist.

In the step of forming resist on the semiconductor substrate employed in lithography during processing the conventional semiconductors (spin coating), the solvent may not be perfectly removed but left in the resist formed on the semiconductor substrate. If the solvent is left in the resist, it is possible that the solvent comes out to the developer during development, causing deformation of the resist pattern or cracks in the resist. Cracks generated in the resist decreases mechanical strength of the resist and, in the LIGA method, results in plating on unnecessary portions, so that microstructure as designed cannot be obtained.

Meanwhile, in the present embodiment, the copolymer including methylmethacrylate and methacrylic acid units is prepared by bulk polymerization, and therefore such deformation of the resist pattern and crack in the resist at the time of development can be suppressed. In accordance with the present invention, the resist can be formed thick on the substrate. In addition, the deformation of resist patterns and the cracks in the resist do not much occur during development in the resist formed in accordance with the present invention. Therefore, according to the present invention, microstructure having high precision and high aspect ratio can be formed by forming, for example, metal structures by electroplating or the like on the substrate in accordance with the resist pattern.

### Embodiment 2

Steps of manufacturing a photomask including an X-ray transmitting membrane formed of a material transmitting the X-ray and an X-ray absorber film formed on the surface of X-ray transmitting membrane with the average thickness of the X-ray absorber film being at least 5µm will be described in the following with reference to Figs. 24 to 31.

First, in the step shown in Fig. 24, an X-ray transmitting membrane 12 of silicon nitride (SiN), silicon carbide (SiC) or the like having the average thickness of about 2µm is formed on one surface 11a of a silicon substrate 11 by chemical vapor deposition or physical vapor deposition. Also in this step, a film 14 of silicon nitride (SiN), silicon carbide (SiC) or the like serving as an etch mask at the back etching of the silicon substrate and the subsequent step, which will be described later, is formed on a prescribed region on the other surface 11b of silicon substrate 11, by chemical vapor deposition or physical vapor deposition. The step shown in Fig. 24 is the same as the conventional step shown in Fig. 10. Then, in the step shown in Fig. 24, an X-ray absorber film 13a of tungsten (W) having the average thickness 5µm is formed on the surface of X-ray transmitting membrane 12 by chemical vapor deposition of physical vapor deposition. In this step, the X-ray absorber film 13a of tungsten (W) tantalum (Ta) or the like can be formed to a desired thickness on the surface of the X-ray transmitting membrane 12 by chemical or physical vapor deposition. The step shown in Fig. 25 is the same as the step shown in Fig. 11 except that the X-ray absorber film 12a is formed thicker than X-ray absorber film 203a of the conventional X-ray mask.

Then, in the step shown in Fig. 26, as in Example 1, in a mixture of 95g (0.95 mole) of methylmethacrylate monomer (molecule weight 100) and 5g (0.051 mole) of methacrylic acid (molecular weight 86), 0.2g (about 0.2 wt.% with respect to the mixture monomers) of 2, 2'-azobis(isobutyronitrile)(AlBN) was added as polymerization initiator, and pre-polymerization is effected for 50 minutes at 60°C in N₂ gas atmosphere by bulk polymerization, whereby a copolymer syrup of methylmethacrylate and methacrylic acid units was prepared. Then, as in the step shown in Fig. 1, a copolymer resist 15 including methylmethacrylate and methacrylic acid units was formed on the surface of the X-ray absorber film 13a to an average thickness of 50µm.

Figs. 32 to 34 show details of the step shown in Fig. 26.

First, in the step shown in Fig. 32, a silicon substrate 11 having, on one surface 11a, X-ray transmitting membrane 12 and X-ray absorber film 13a on the surface of the X-ray transmitting membrane 12, and on the other surface 11b a film 14 at a prescribed region, is placed on a hot plate 21, and a spacer is provided to surround silicon substrate 11. Then, in the step shown in Fig. 33, the copolymer syrup 24 including methylmethacrylate and methacrylic acid units prepared in the above described manner is dropped to fill the spacer 23. Then, in the step shown in Fig. 34, a Kapton sheet (mold releasing sheet) 25 is placed on spacer 23, a metal plate 26 is placed on Kapton sheet 25, a weight 27 is placed on metal plate 26, and the substrate is kept at 70°C for one hour by hot plate 21 so as to fully polymerized the copolymer syrup 24 including methylmethacrylate and methacrylic acid units on X-ray absorber film 13a, and thus a copolymer resist 15 including methylmethacrylate and methacrylic acid units is provided.

Then, in the step shown in Fig. 27, an X-ray mask 30 having a desired pattern manufactured in accordance with the conventional method (having the average thickness 33d of X-ray absorber film 33 of 0.7µm), which was used in the prior art for electronic beam or ultraviolet ray, is employed and by a synchrotron orbital radiation apparatus (TERAS) of Electrotechnical Laboratory, Agency of Industrial Science and Technology, the synchrotron orbital radiation of the 0th order having the peak wavelength of about 10Å is emitted through a Be window.

The amount of radiation was 70mA•hr to 90mA•hr in terms of the accumulated beam current value.

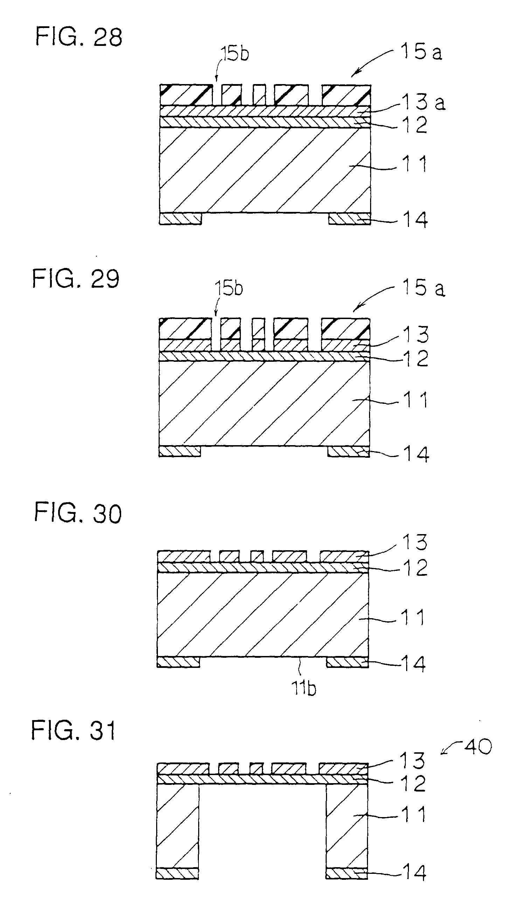

In the step shown in Fig. 28, silicon substrate 11 having on its surface said resist layer exposed in the above described manner is dipped in stock solution of methylisobutylketone (MIBK) for about 2 minutes at a room temperature, with the silicon substrate 11 kept stationary for development. In this step, reduction in thickness of the resist layer was not observed.

The copolymer resist 15 including methyl methacrylate and methacrylic acid units has high sensitivity to the synchrotron orbital radiation. Therefore, the copolymer resist 15 including methylmethacrylate and methacrylic acid units can be exposed deeply by a short period of synchrotron orbital radiation. Since the copolymer resist including methylmethacrylate and methacrylic acid units is exposed with small amount of synchrotron orbital radiation, the radiation can be sufficiently intercepted by the X-ray mask 30 with the X-ray absorber film 33 having the average thickness 33d of 0.7µm. Undesired portions of the resist are not exposed, and therefore highly precise resist pattern 15a can be obtained with highly productivity.

In the step shown in Fig. 29, X-ray absorber film 13a exposed through an opening 15b is etched by RIE method by using the resist pattern 15a formed in the step of Fig. 28 as a mask, so that X-ray absorber film 13a is penetrated. For etching the absorber film 13a having the average thickness of 5µm, a know RIE dry etching apparatus, is used under the following conditions.

**Table 2**

| Conditions for Etching | |
|---|---|
| Etching Gas (SCCM) | SF₆ : 25 (SCCM) |
| | CHF₃: 25 (SCCM) |
| Gas Pressure (Pa) | 15 (Pa) |
| Distance between Electrodes (mm) | 80 (mm) |
| RF power | 500 (W) |
| Etch Time (min.) | 70 min. |

In this manner, an X-ray absorber film 13 having a desired pattern of high precision having the average film thickness of 5µm could be provided.

In the step shown in Fig. 30, after the resist layer is removed, the silicon substrate 11 is etched away (back etch) from the other surface 11b of the substrate 1 by using KOH solution, with the film 14 used as an etching mask, whereby the X-ray mask 40 of the present invention is obtained (see Fig. 31).

According to Embodiment 2, not by the photolithography employing the conventional electronic beam drawing or ultraviolet ray (having the wavelength of about 3000Å to 5000Å) but by X-ray lithography employing synchrotron orbital radiation and by the conventional etching, an X-ray mask having the X-ray absorber film having the average thickness of at least 5µm could be easily formed.

In Embodiment 2, a copolymer resist 15 including methylmethacrylate and methacrylic acid units was formed to the average thickness of 50µm on the surface of the X-ray absorber film 13a. However, the X-ray mask including an X-ray absorber film 13 with the average thickness of at least 5µm, which could not be formed in accordance of the conventional method of manufacturing the X-ray mask can be obtained provided that the average thickness of the copolymer resist 15 is at least 20µm, by forming a resist pattern 15a having an opening 15b by using X-ray of synchrotron orbital radiation having the thickness of about 10Å and by etching the X-ray absorber film 13a by using the resist pattern 15a as a mask.

Referring to Fig. 28, resist pattern 15a formed on X-ray absorber film 13a was approximately vertical to the surface of X-ray absorber film 13a, and it has superior dimensional precision. Therefore, by etching the X-ray absorber film 13a using resist pattern 15a as a mask, X-ray absorber 13 having accurate dimension can be formed.

The disclosure in Embodiment 2 is only an example of the present invention and the scope of coverage is not limited thereto.

According to the present invention, the resist can be formed thick, and a resist pattern having an opening deep in the thickness direction of the resist (depth direction) can be formed. Therefore, by etching the substrate portion exposed through the opening by using the resist pattern as a mask, a microstructure having high aspect ratio with a deep recess in the substrate can be formed.

Although lithography employing a copolymer resist including methylmethacrylate and methacrylic acid units has been described in the above Embodiments 1 and 2, it is simply for the sake of description and the present invention is not limited to a method of forming a microstructure including a step of lithography employing a copolymer resist including methylmethacrylate and the methacrylic acid units.

Any copolymer resist such as copolymer resist including methacrylic acid units ester and methacrylic acid units, copolymer resist including methacrylic acid ester and methacryloylhalogenoid units, a copolymer resist including methacrylic acid ester and acrylic acid units, a copolymer resist including other methacrylic acid ester and acryloyl halogenoid units may be used to provide the same effect, provided that the copolymer resist has similar chemical reaction mechanism as the above described copolymer resist including methylmethacrylate and methacrylic acid units.

As described above, according to the present invention, a micro structure having high aspect ratio can be obtained especially by the LIGA method.

According to the present invention, in the LIGA method, for example, a microstructure having high aspect ratio which could be obtained only by a large synchrotron orbital radiation apparatus having high performance when PMMA was used as a resist can be formed by a small general purpose synchrotron orbital radiation apparatus, by using the resist of the present invention which has improved sensitivity.

Since the resist sensitivity of the present invention is higher than that of PMMA, the resist can be exposed in a short period of time, and therefore time necessary for forming microstructure can be reduced.

The resolution of the resist can be improved by reducing diffraction effect of light, that is, by using light having shorter wavelength. By the present invention, it can be also improved by the chemical reaction mechanism and the development mechanism of the resist.

In addition, in accordance with the present invention, since the resist can be formed thick and a resist pattern having high aspect ratio can be formed, a microstructure having high aspect ratio can be formed in the field of forming three-dimensional structure by microprocessing, especially in the field of LIGA.

According to the present invention, the resist can be formed thick on the surface of the substrate, and the resist pattern having an opening with high aspect ratio can be formed. As a result, by etching away the substrate portion exposed through the opening using the resist pattern as a mask, a microstructure having protruding and depressed portions with high aspect ratio at the substrate portion can be formed.

By using the X-ray mask formed by a method in accordance with the present invention, especially in the method of forming a microstructure employing LIGA method, after the resist is formed thick on the substrate, the X-ray absorber film can sufficiently intercept the X-ray of synchrotron orbital radiation, even when the X-ray of synchrotron orbital radiation is applied for a long time using the X-ray mask of the present invention on the resist layer. Therefore, by using the X-ray mask, the resist pattern having higher aspect ratio can be formed easily as compared with the conventional X-ray mask used in manufacturing semiconductor integrated circuits. By using the X-ray mask in accordance with the present invention, the resist pattern having high aspect ratio can be formed, and therefore, in the field of forming a three-dimensional structure by microprocessing, especially in LIGA method, a microstructure having high aspect ratio can be formed.

Although the present invention has been described and illustrated in detail, it is clearly understood that the same is by way of illustration and example only and is not to be taken by way of limitation, the spirit and scope of the present invention being limited only by the terms of the appended claims.

## Claims

1. Method of forming a microstructure, comprising:
forming a resist layer (4; 15) on a substrate (2; 13a); and
patterning said resist layer (4;15);
wherein said step of forming said resist layer (4; 15) includes pre-polymerizing a first monomer generally represented as 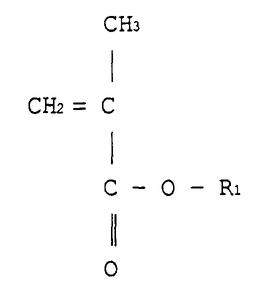
where R₁ represents an ahkyl group having one to four carbon atom(s) and a hydrogen atom of the alkyl group may be substituted for by a halogen atom; and a second monomer generally represented as 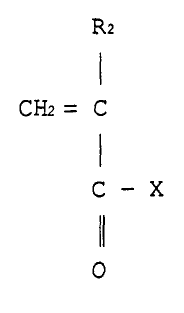
where X represents a halogen atom or a hydroxyl group and R₂ represents a hydrogen atom or a methyl group, for preparing a copolymer syrup consisting of said first and second monomers;
applying said copolymer syrup on said substrate, and fully polymerizing said copolymer syrup on said substrate.

2. Method according to claim 1, wherein said steps of patterning includes forming a resist pattern of said resist layer (2; 13a) by lithography with synchrotron orbital radiation.

3. Method according to claim 2, wherein said step of patterning includes forming a resist pattern having an opening, by lithography with synchrotron orbital radiation, and which further comprises removing by etching a portion of said substrate exposed through said opening by using said resist pattern as a mask.

4. Method according to claim 3, wherein said copolymer syrup is free of solvent.

5. Method for forming an X-ray mask by a method according to claim 3, including additionally an X-ray transmitting membrane consisting of a material that is transmissive to X-rays and an X-ray absorber film arranged on a surface of said X-ray transmitting membrane, wherein said X-ray absorber film has an average thickness of at least 5 µm.

## Patentansprüche

1. Verfahren zur Ausbildung einer Mikrostruktur, umfassend:
Ausbilden einer Abdeckungsschicht (4; 15) auf einem Substrat (2; 13a); und
Versehen der Abdeckungsschicht (4; 15) mit einem Muster;
wobei der Schritt des Ausbildens der Sperrschicht (4; 15) die Präpolymerisierung eines ersten Monomers, welches allgemein dargestellt wird durch 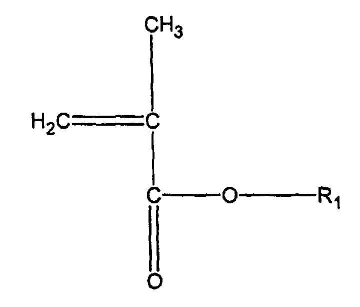
wobei R₁ eine Alkylgruppe darstellt, die ein bis vier Kohlenstoffatom(e) aufweist, und ein Wasserstoffatom der Alkylgruppe durch ein Halogenatom ersetzt werden kann;
und eines zweiten Monomers beinhaltet, welches allgemein dargestellt wird durch 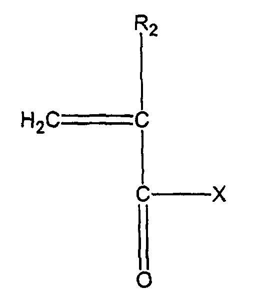
wobei X ein Halogenatom oder eine Hydroxylgruppe und R₂ ein Wasserstoffatom oder eine Methylgruppe darstellt,
um ein Copolymersirup herzustellen, der aus dem ersten und zweiten Monomer besteht;
Aufbringen des Copolymersirups auf dem Substrat, und
vollständiges Polymerisieren des Copolymersyrups auf dem Substrat.

2. Verfahren nach Anspruch 1, wobei der Schritt des Versehens mit einem Muster das Ausbilden eines Abdeckungsmusters aus der Abdeckungsschicht (2; 13a) mittels Lithographie mit Bahnsynchrotronstrahlung beinhaltet.

3. Verfahren nach Anspruch 2, wobei der Schritt des Versehens mit einem Muster das Ausbilden eines Abdeckungsmusters mit einer Öffnung mittels Bahnsynchrotronstrahlung einschließt, und welches ferner das Entfernen eines Teils des Substrates durch Ätzen umfaßt, welcher durch die Öffnung durch die Verwendung des Abdeckungsmusters als Maske freigelegt ist.

4. Verfahren nach Anspruch 3, wobei der Copolymersirup frei von Lösungsmittel ist.

5. Verfahren zur Ausbildung einer Röntgenstrahlenmaske durch ein Verfahren nach Anspruch 3, welche zusätzlich eine einen Röntgenstrahl durchlassende Membran enthält, die aus einem Material, welches für Röntgenstrahlen durchlässig ist, und einem Röntgen-Absorberfilm besteht, der auf einer Oberfläche der Röntgenstrahl durchlassenden Membran angeordnet ist, wobei der Röntgen-Absorberfilm eine Durchschnittsdicke von wenigstens 5 µm aufweist.

## Revendications

1. Procédé de formation d'une microstructure, comprenant :
la formation d'une couche de résist (4 ; 15) sur un substrat (2 ; 13a) ; et
la formation d'un motif dans ladite couche de résist (4 ; 15) ;
où ladite étape de formation de ladite couche de résist (4 ;15) inclut la pré-polymérisation d'un premier monomère représenté généralement par 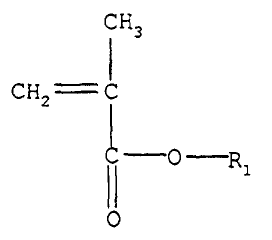
où R₁ représente un groupe alkyle ayant un à quatre atomes de carbone, et un atome d'hydrogène du groupe alkyle peut être remplacé par un atome d'halogène ;
et d'un second monomère représenté généralement par 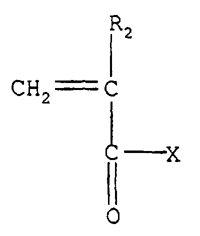
où X représente un atome d'halogène ou un groupe hydroxyle et R₂ représente un atome d'hydrogène ou un groupe méthyle, pour préparer un sirop de copolymère consistant en lesdits premier et second monomères ;
l'application dudit sirop de copolymère sur ledit substrat, et la polymérisation totale dudit sirop de copolymère sur ledit substrat.

2. Procédé selon la revendication 1 où ladite étape de formation d'un motif comprend la formation d'un motif de résist dans ladite couche de résist (2 ; 13a) par lithographie avec un rayonnement orbital synchrotron.

3. Procédé selon la revendication 2 où ladite étape de formation d'un motif inclut la formation d'un motif de résist ayant une ouverture, par lithographie avec un rayonnement orbital synchrotron, et - qui comprend en outre le retrait par gravure d'une partie dudit substrat exposée par ladite ouverture au moyen dudit motif de résist qui joue le rôle de masque.

4. Procédé selon la revendication 3 où ledit sirop de copolymère est exempt de solvant.

5. Procédé de formation d'un masque pour rayons X par un procédé selon la revendication 3 incluant en outre une membrane transmettant les rayons X consistant en un matériau qui transmet les rayons X et un film absorbant les rayons X disposé sur une surface de ladite membrane transmettant les rayons X, où ledit film absorbant les rayons X a une épaisseur moyenne d'au moins 5 µm.
